Europäisches Patentamt

European Patent Office

Office européen des brevets

(19)

(11) Publication number: 0 311 446
A2

## (12) EUROPEAN PATENT APPLICATION

(21) Application number: 88309412.0

(22) Date of filing: 07.10.88

(51) Int. Cl.⁴: C 30 B 25/14
C 23 C 16/44

(30) Priority: 08.10.87 JP 254313/87
08.10.87 JP 254314/87

(43) Date of publication of application:
12.04.89 Bulletin 89/15

(84) Designated Contracting States: DE FR GB NL

(71) Applicant: MITSUBISHI RAYON CO. LTD
2-3-19, Kyobashi Chuo-ku
Tokyo (JP)

(72) Inventor: Ichimura, Kiyoshi
5-17-15, Kyodo Setagaya-ku
tokyo (JP)

Tsushi, Akihito
3-11-15, Katahira Asou-ku
Kawasaki-shi Kanagawa-ken (JP)

Kawanishi, Hideo
3-12-23, Ogawa
Machida-shi Tokyo (JP)

(74) Representative: Senior, Alan Murray et al
J.A. KEMP & CO 14 South Square Gray's Inn
London WC1R 5EU (GB)

(54) Apparatus for producing compound semiconductor.

(57) In apparatus for producing compound semiconductor by applying vaporized organometal compound onto a substrate (15) carried by a susceptor (16), pressure of organometal compound gas is detected by a pressure sensor (1) at an outlet side of a bubbler (18) which vaporizes starting organometal compound for effecting feedback control. The pressure information is used to control flow rate of carrier gas (10) fed to the bubbler (18). The feedback controlled organometal compound gas (11) is fed via a mass flow controller (3B) to a reaction tube (14) in which the susceptor (16) is provided. An upper surface (43) of the susceptor (16) is inclined by an angle which is less than 45 degrees with respect to horizontal plane including axis of gas flow applied to the substrate (15) within the horizontal reaction tube (14), while the susceptor (16) is rotated about its center axis perpendicular to the upper surface (43) thereof. Feedback control may be effected by detecting the pressure of an exhaust gas from the reaction tube.

FIG. 1

**Description**

## APPARATUS FOR PRODUCING COMPOUND SEMICONDUCTOR

This invention relates to vapor phase semiconductor crystal-growing apparatus arranged to process a starting material of organometal compound.

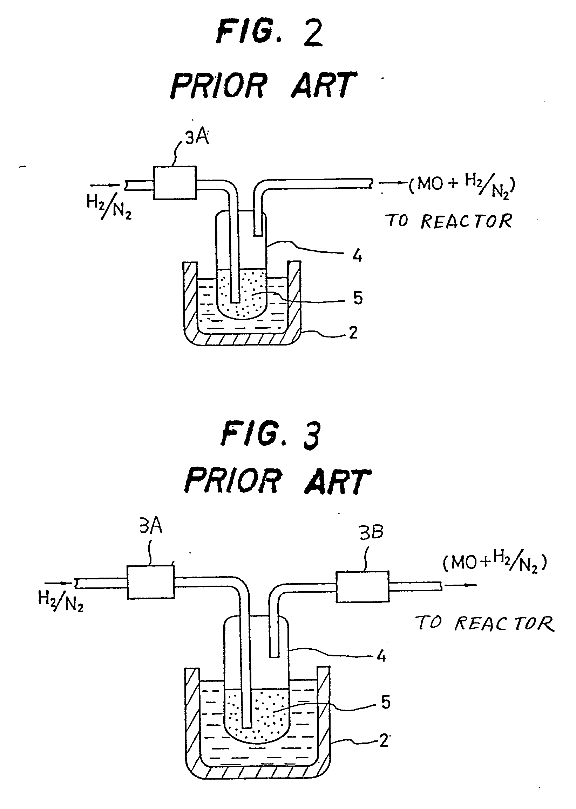

In one method of producing a semiconductor by using organometal (metal organic) vapor phase growth a carrier gas such as hydrogen or nitrogen is introduced into a container containing liquefied organometal compound to effect bubbling thereby producing a vapor phase organometal compound, and then sending the vapor phase organometal compound to a reactor with a carrier gas. The rate of flow of the vapor phase organometal compound is controlled by way of a flow rate control system shown in Fig. 2. More specifically, the rate of flow of a carrier gas including, for instance, hydrogen and nitrogen, is accurately controlled by way of a mass flow controller 3A in the carrier gas input tube a container of liquid organometal compound 5. As a result, the amount of vapor phase organometal compound included in the carrier gas to be sent to a reactor is controlled indirectly. Although this method cannot provide a high accuracy in the rate of flow of vapor phase organometal compound to the reactor, this method has hitherto been popular for the following two reasons.

Firstly, in the case that a semiconductor crystal to be obtained is of a ternary compound, such as AlGaAs, a semiconductor device having a practically high performance can be produced even if the supply amount of the various organometal compound components used as raw materials is not accurately controlled. Secondly, if a further mass flow controller were provided between the container and the reactor for further accurately controlling the amount of vapor phase organometal compound to be fed to the reactor, the inner wall of such mass flow controller is apt to suffer from deposit and formation of solid organometal compound due to the rapid and vigorous reaction of vapor phase organometal compound. As a result, the gas passage of the mass flow controller is narrowed or blocked, and therefore, accurate mass flow control cannot be effected.

According to another known method two mass flow controllers are provided such that one is before the container and the other is after the container so as to increase the supply control accuracy. However, this method also suffers from the same problem as mentioned above. Furthermore, in the case of producing a multi-layered double hetero-crystal, it is necessary to change rapidly the kind of organometal compound to be fed to the reactor When using the structure of Fig. 2 for producing such semiconductor, various organometal compound supply lines each including a bubbler are connected via a cock or the like to outlet side of the single mass flow controller. However, it is difficult to control accurately the amount of vapor phase organometal compounds supplied to the reactor when using the structure of Fig. 2. Therefore, in a conventional system, a plurality of mass flow controllers are used for respective organometal compound supply lines such that one of the mass flow controllers is selectively used one after another thereby minimizing the change in flow rate on changeover.

As described in the above, the conventional system of Fig. 2 cannot provide very accurate control of flow rate of organometal compound to be supplied to a reactor, while another conventional system of Fig. 3 cannot provide satisfactory control characteristic unless the control accuracy of one mass flow controller exactly equals that of the other mass flow controller since these two mass flow controllers are connected in series. More specifically, when the flow rate of the mass flow controller 3B provided after the organometal compound container 4 is set to a value larger than that of the mass flow controller 3A provided before the organometal compound container 4, the flow rate of organometal compound to be fed to the reactor is determined by the mass flow controller 3A, and therefore, the provision of the mass flow controller 3B has no meaning. On the contrary, when the flow rate is set opposite to the above, the pressure of vapor of organometal compound is varied, and as a result, the mass flow controller 3B cannot show the desired control characteristic. If the means flow controller 3B were provided only after the container 4, the pressure of organometal compound vapor would be uncontrollable, and therefore accurate control of organometal compound cannot be effected.

Moreover, when a plurality of organometal compound supply lines are used, the entire system becomes complex while a plurality of organometal compound containers are required thereby increasing cost and thus it is difficult to provide a system having flexibility.

In accordance with the present invention there is provided apparatus for producing compound semiconductor having a bubbler for producing vaporized organometal compound by leading a carrier gas thereinto, and a reaction tube for performing vapor phase growth of a semiconductor crystal on a substrate by leading said vaporized organometal compound to said reaction tube, characterised by first means provided between said bubbler and said reaction tube for accurately controlling flow rate of said vaporized organometal compound, second means for detecting pressure of said vaporised organometal compound at outlet side of said bubbler, and third means provided at inlet side of said bubbler for controlling flow rate of said carrier gas in accordance with an output signal from said second means.

In accordance with a further aspect of the present invention, there is provided apparatus for producing compound semiconductor having a bubbler for producing vaporised organometal compound by leading a carrier gas thereinto, a reaction tube for performing vapor phase growth of a semiconductor crystal on a substrate by leading said vaporized organometal compound to said reaction tube, and an exhauster communicated with an outlet of said reaction tube via an exhaust pipe for exhausting said vaporized organometal compound from said reaction tube characterised by means responsive to pressure of said exhaust gas for maintaining pressure of said vaporized organometal compound within said reaction tube substantially constant.

Thus with these aspects of the present invention apparatus for producing a compound semiconductor can be constructed in which the pressure of an organometal compound gas within a reaction tube is kept constant for producing a semiconductor layer of uniform quality by detecting either the starting gas pressure at an outlet side of a bubbler which produces vaporized organometal compound to perform feedback control or the exhaust gas pressure in an exhaust pipe following the reactor to perform feedback control. Such feedback controls at inlet side and outlet side of the reactor may be performed simultaneously to obtain further accurate control. With the provision of such feedback control, a closed system is established in the supply system of organometal compound and/or exhaust system.

In accordance with yet a further aspect of the present invention there is provided apparatus for producing compound semiconductor having a reaction tube for performing vapor phase growth of a semiconductor crystal on a substrate carried by a susceptor by leading vaporized organometal compound to said reaction tube, characterised in that an upper surface of said susceptor is in inclined by an angle less than 45 degrees with respect to the general direction of flow of said vaporized organometal, and by means for rotating said susceptor about a center axis which is perpendicular to said upper surface of said susceptor.

Preferably, said reaction tube is a horizontal reaction tube so that said vaporized organometal compound is supplied in a horizontal direction to said substrate and said upper surface of the susceptor is inclined at an angle of less than 45 degrees to the horizontal.

Accordingly the susceptor carrying the substrate is inclined at a given angle less than 45 degrees with respect to horizontal plane corresponding to the axis of gas flow within a horizontal reaction tube, and this susceptor is rotated to rotate the substrate thereby causing organometal compound gas flow to hit the substrate in a successively varying direction.

In accordance with the present invention there is further provided apparatus for producing compound semiconductor having a bubbler for producing vaporized organometal compound by leading a carrier gas thereinto, and a reaction tube for performing vapor phase growth of a semiconductor crystal on a substrate carried by a susceptor by leading said vaporized organometal compound to said reaction tube, characterised by first means provided between said bubbler and said reaction tube for accurately controlling flow rate of said vaporized organometal compound, second means for detecting pressure of said vaporized organometal compound at outlet side of said bubbler, third means provided at inlet side of said bubbler for controlling flow rate of said carrier gas in accordance with an output signal from said second means, in that an upper surface of said susceptor is inclined by an angle less than 45 degrees with respect to the general direction of flow of said vaporized organometal compound and by means for rotating said sdusceptor about a center axis which is perpendicular to said upper surface of said susceptor.

In accordance with the present invention there is further provided apparatus for producing compound semiconductor having a bubbler for producing vaporized organometal compound by leading a carrier gas thereinto, a reaction tube for performing vapor phase growth of a semiconductor crystal on a substrate by leading said vaporized organometal compound to said reaction tube, and an exhauster communicated with an outlet of said reaction tube via an exhaust pipe for exhausting said vaporized organometal compound from said reaction tube, characterised by first means provided between said bubbler and said reaction tube for accurately controlling flow rate of said vaporized organometal compound, second means for detecting pressure of said vaporized organometal compound at outlet side of said bubbler, third means provided at inlet side of said bubbler for controlling flow rate of said carrier gas in accordance with an output signal from said second means, and fourth means responsive to pressure of said exhaust gas for maintaining pressure of said vaporized organometal compound within said reaction tube constant.

The invention will be further described by way of non-limitative example with reference to the accompanying drawings, in which:

Fig. 1 is a schematic diagram of an embodiment of the apparatus for producing a compound semiconductor according to the present invention;

Figs 2 and 3 are schematic diagrams showing organometal compound gas flow rate control apparatus used in prior art compound semiconductor producing apparatus;

Fig. 4A is a cross sectional side view of the reaction tube used in the apparatus of Fig. 1;

Fig. 4B is a top plan view of a portion within the reaction tube shown in Fig. 4A;

Fig. 5 is a schematic diagram of a second embodiment of the present invention;

Fig. 6 is a schematic diagram of a modification of the second embodiment;

Fig. 7 is a graphical representation showing variation of measured pressure in bubbler, pressure in reaction tube, and gas flow rate on changeover of gas lines; and

Fig. 8 is a graphical representation showing measured photoluminescence intensity using a semiconductor obtained by the apparatus according to the present invention.

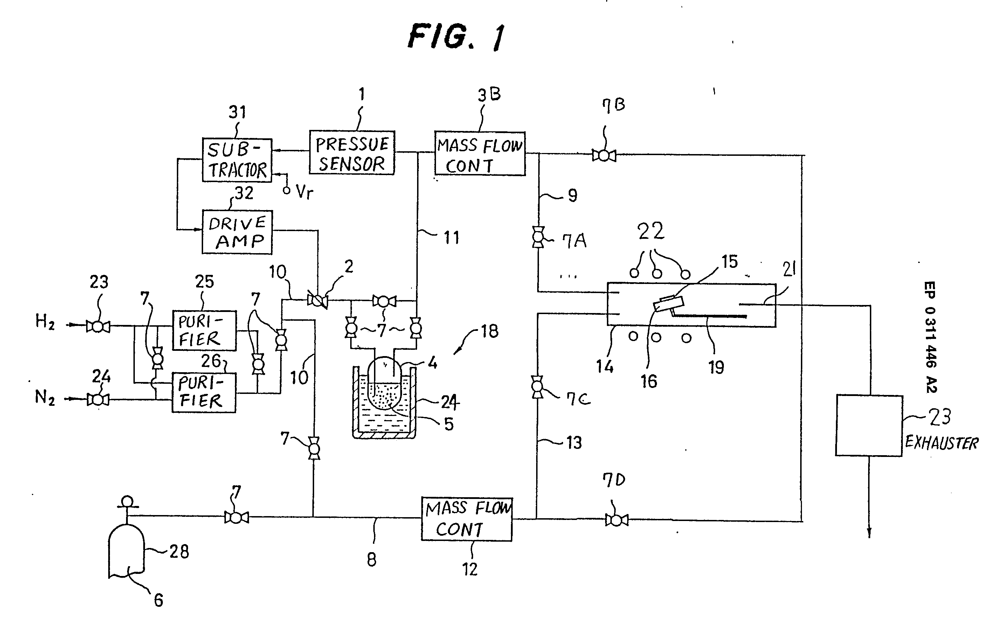

Referring now to Fig. 1, a schematic diagram of an embodiment of a semiconductor producing apparatus according to the present invention is shown. The semiconductor producing apparatus generally comprises a pressure sensor 1, a bubbler 18 having an organometal compound container 4, a container inlet valve 2, a mass flow controller 3B, and a reactor or reaction tube 14. The container inlet valve 2 is of flow rate controllable type and is responsive to a signal derived from the pressure sensor 1. In the container 4 is held organometal compound 5 which is a starting material of Group III of periodic table, while a hydrogen compound 6 of Group V is held in a bomb 28 or cylinder. Hydrogen ($H_2$) and nitrogen ($N_2$) to be used as carrier gases are respectively fed via valves 23 and 24 to purifiers 25 and 26, and purified gases are combined to make a carrier gas mixture 10 of $H_2$ and $N_2$. This mixed carrier gas 10 is fed via a variable flow rate solenoid valve 2 to an inlet of the bubbler 18. An outlet of the bubbler 18 is connected via the mass flow controller 3B to the reaction tube 14. The pressure sensor 1 is provided for detecting the pressure of the organometal compound gas 11 at the outlet side of the bubbler 18. The pressure sensor 1 produces an output signal indicative of detected pressure of organometal compound gas 11 and this signal is fed to one input terminal of a subtractor 31 having another input terminal for receiving a reference voltage Vr. An output signal corresponding to the difference between the signal from the pressure sensor 1 and the reference voltage Vr is fed to a drive amplifier 32 whose output signal is fed to a control terminal of the variable flow rate solenoid valve 2.

On the other hand, the bomb 28 containing hydrogen compound of Group V is connected via another mass flow controller 12 to the reaction tube 14. In Fig. 1, the reference numeral 7 and numerals 7A, 7B, 7C and 7D indicate manually operable valves. The bubbler 18 comprises a constant temperature bath 21 for maintaining the temperature of the container 4 containing organometal compound 5 constant with the container 4 being received in the constant temperature bath 24. Since the pressure of organometal compound vapor is sensitively dependent on the temperature of the organometal compound container 4, accurate temperature control by way of the constant temperature bath 24 provides improved pressure control characteristic.

Around the reaction tube 14 is provided a high frequency heating coil 22, and one end or outlet of the reaction tube 14 is connected to an exhauster 23 via an exhaust pipe 21. Within the reaction tube 14 is provided a susceptor 16 held by a susceptor holder or supporting shaft 19. The reaction tube 14 is of horizontal type, and vapor organometal compound which is a starting material of a compound semiconductor is supplied in a horizontal direction. The susceptor 16 is rotatably attached to the susceptor holder 19 such that the upper surface of the susceptor 16 makes an angle less than 45 degrees with respect to a horizontal plane. This angle is preferably between 3 and 30 degrees so that the flow of organometal compound gas from one end, i.e. left end in Fig. 1, of the horizontal reaction tube 14 hits the upper surface of the susceptor 16. The susceptor 16 is arranged to rotate about a center axis of the supporting shaft 19 which is perpendicular to the upper surface of the susceptor 16, and vapor phase growth is effected with the susceptor 16 being rotated.

In a conventional horizontal reaction tube, since the vapor phase growing speed at an upstream portion in a starting material gas flow is high, the density of the starting material and the composition of the starting materials at a downstream portion are apt to be different from those of upstream portion. For this reason, such conventional horizontal reaction tube is not satisfactory for producing a semiconductor layer with accurate epitaxial growth, stoichiometric control, and lattice mismatching control. For instance, using a GaAs substrate of 1 cm by 1 cm to produce a compound semiconductor under the same conditions as those of the present invention without rotating substrate in the same manner as a comparison example which will be described hereinlater, the variation of lattice mismatching rate at various places of an epitaxial growth layer is as high as $\pm$ 0.25 %. It is deemed that this variation is caused from uneven density distribution of reactive gas components above the substrate. More specifically, the density ratio X between two organometal compounds is given by:

$$X = \frac{A}{A + B}$$

wherein A and B are density of used organometal compounds, and this density ratio X has a linear relationship with lattice mismatching rate $\Delta a/a$, and therefore nonuniform density distribution causes such variations. According to the present invention, the susceptor 16 carrying the substrate 15 is inclined with respect to horizontal plane by an angle less than 45 degrees as mentioned in the above, and the susceptor 16 is rotated at a speed less than 3 rpm during vapor phase growth, and therefore, compound semiconductor grows at every point on the substrate 15 uniformly.

The pressure of reactive gas component led into the reaction tube 14 is regulated to be constant all the time by feedback control of the pressure. More specifically, in Fig. 1, the pressure sensor 1 detects the pressure at the outlet side of the bubbler 18, and this pressure information is fed back to control the flow rate of carrier mixture gas 10 by way of the variable flow rate solenoid valve 2.

The operation of the apparatus of Fig. 1 will be described in detail hereinbelow. The mixed carrier gas 10 obtained by combining purified hydrogen gas and nitrogen gas from purifiers 25 and 26 is fed via the variable flow rate solenoid valve 2 to the inlet of the bubbler 18. As a result, bubbling is effected in the liquid organometal compound 5 contained in the container 4, and then a mixture 11 of vaporized organometal compound and the mixed carrier gas 10 is outputted from the bubbler 18 to be fed via the mass flow controller 3B to the reaction tube 14. The pressure of the mixture 11 at the outlet side of the bubbler 18 or container 4 is measured by the pressure sensor 1, and an output signal from the pressure sensor 1 is processed through the subtractor 31 to produce a drive signal by the drive amplifier 32. The variable flow rate solenoid valve 2 is controlled by the drive signal from the drive amplifier 32 so as to perform feedback control of the pressure of the mixture 11. As a result, the pressure of the mixture 11 at the outlet side of the bubbler 18 is maintained at a setting pressure represented by the reference voltage Vr fed to the subtractor 31.

The mixture 11 of the vaporized organometal compound and the inactive mixed carrier gas 10, whose pressure is regulated in the above-mentioned manner, is passed through the mass flow controller 3B so that a final mixture 9 whose organometal compound amount and flow rate are accurately controlled is fed to the reaction tube 14.

Since hydrogen compound of Group V is a gas at normal temperatures, the flow rate control thereof is relatively easy when compared with organometal compound. A mixed gas 8 obtained by mixing hydrogen compound 6 with the inactive gas 10 which is a mixed gas of $H_2$ and $N_2$, is passed through the mass flow controller 12 so that a mixed gas 13 is fed to the reaction tube 14 where the flow rate of hydrogen compound is controlled accurately. In this way, compound gases of Group III and Group V are respectively fed to the reaction tube 14 with the supply amount of the starting materials being controlled accurately. Then an epitaxial layer is grown on the substrate 15 which is heated by the high frequency heating coil 22 while the substrate 15 is rotated as described in the above. Since the epitaxial layer is formed in this way, the controllability of the components of the epitaxial layer has been remarkably improved.

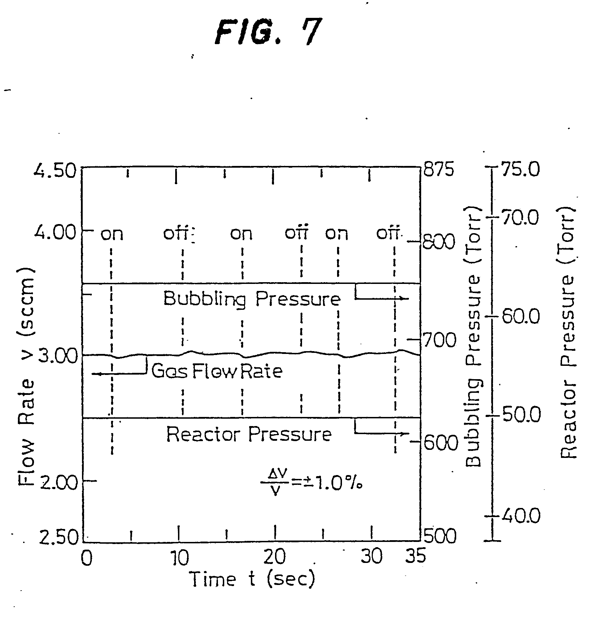

With the apparatus according to the present invention, the variation of the pressure of the mixed gas including the organometal compound can be controlled with tolerance of ± 0.1 Torr, and therefore, the pressure of gases within the reaction tube 14 can also be maintained constant. This is because the flow rate control of the starting gas by way of the mass flow controller 3B can be performed with high accuracy with the feedback control of the vapor gas of organometal compound. The control accuracy or resolution is as high as 0.01 sccm in terms of flow rate. An actual epitaxial growth is performed by changing the path of flow of organometal compound gas between exhaust system including valves 7B and 7D and the exhauster 23, and reaction tube system including valves 7A and 7C and the reaction tube 14. Varying characteristics of bubbling pressure within the container 4, pressure in the reaction tube 14, and gas flow rate on such successive flow change between exhaust system and reaction tube system are shown in Fig. 7. The pressure in the reaction tube 14 is kept constant at 50 Torr, and the bubbling pressure does not vary irrespective of the changeover of organometal compound gases. The variation rate of the organometal compound gas can be controlled to be within ± 1 %.

One example of epitaxial growth of a crystal using the above-mentioned characteristics will be described hereinbelow. In this example, the constituents are 0.12 of In, 0.88 of Ga, 0.75 of As and 0.25 of P, and a crystal is epitaxially grown on the substrate 16. The organometal compounds which are starting materials of Group III are trimethylindium (TMIn) and trimethylgallium (TMGa). In order to use two starting materials of Group III, another control system for the starting material of Group III is provided in parallel to that of Fig. 1. Starting materials of Group V are arsine ($AsH_3$) and phosphine ($PH_3$), and another control system for the starting materials of Group V is also provided in parallel to that of Fig. 1.

The conditions for growth are as follows:

growing temperature    700 °C;

reaction tube pressure    20 Torr;

V/III ratio    114;

average flow rate of gas    24 cm/sec.

Under the above conditions, and when TMGa/(TMGa + TMIn) = 0.85, the lattice mismatching degree $|\Delta a/a|$ can be reduced to a value smaller than ± 0.03 which is less than measuring limit. In the above equation, TMGa indicates molecular density of trimethylgallium, and TMIn indicates molecular density of trimethylindium. The amount of Ga can be controlled in the order of 0.004, while the amount of As can also be controlled in the order of 0.01. Such improvement is caused from the improvement in control resolution of the mass flow controller 3B.

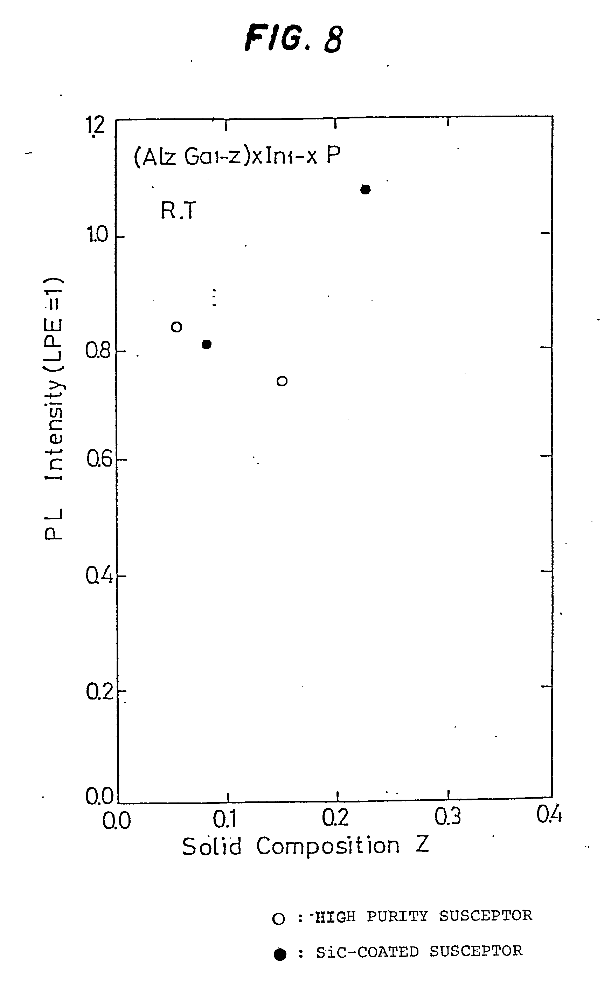

In another example, a system of trimethylaluminum (TMAl) is added to be parallel to the system of element of Group III to effect epitaxial growth of $(Al_zGa_{1-z})_xIn_{1-x}P$ on a substrate of GaAs. In this example, the pressure within the reaction tube 14 is 50 Torr, and the growing temperature is 715 ± 10 °C. As hydrogen compound including element of Group V is used phosphine. Epitaxial growth of $(Al_zGa_{1-z})_xIn_{1-x}P$ is performed with the value of "z" being changed, and photoluminescence at a room temperature is measured. The result of this measurement is shown in Fig. 8. In the diagram of Fig. 8, LPE = 1 indicates that the light emitting intensity of photoluminescence of a compound semiconductor $Ga_{0.52}In_{0.48}As_{0.01}P_{0.99}$ grown by liquid phase growth is set to 1.

As will be understood from the graph of Fig. 8, by using the apparatus according to the present invention and by using the above-mentioned growing conditions, a satisfactory layer having sufficient light emitting intensity and mirror-like surface can be effectively grown in a range up to z = 0.23.

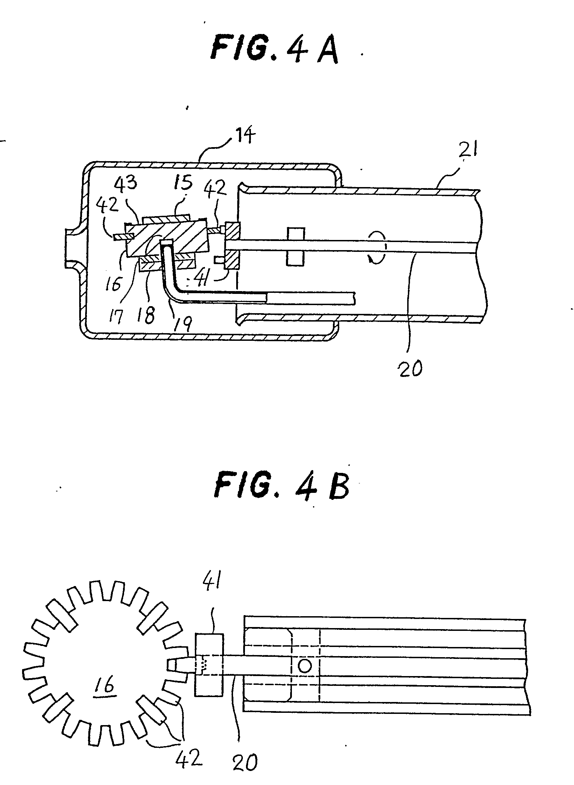

Fig. 4A is a cross sectional view of the reaction tube 14 shown in Fig. 1. Within the horizontal reaction tube 14 is rotatably mounted the susceptor 16 which is used for carrying and holding the substrate 15. As described in the above, the upper surface 43 of the susceptor 16 is inclined by 5 degrees from the horizontal plane, and this angle may be increased and decreased if necessary where larger the angle higher the efficiency in vapor phase growth. At the left end of the reaction tube 14 in the drawing an opening or inlet is provided for introducing compound semiconductor starting materials into the inside of the reaction tube 14. Into the right opening or outlet of the reaction tube 14 is telescopically inserted the exhaust pipe 21 which communicates with the exhauster 23 of Fig. 1.

A rotary shaft 20 is rotatably mounted at a center portion of the exhaust pipe 21 for rotating the susceptor 16, and a gear 41 is attached to the left end of the rotary shaft 20. The rotary shaft 20 is connected to an unshown motor provided outside the exhaust pipe 21 so as to function as a drive source, and the rotationally driving force of the motor is transmitted to the gear 41. The gear 41 engages castellated portions or teeth 42 provided around the susceptor 16 as best seen in Fig. 4B. Thus, the rotation of the gear 41 causes the susceptor 16 to rotate about the supporting shaft 19 which is perpendicular to the upper surface 43 of the susceptor 16.

The horizontal reaction tube 14 is made of silica glass and its inner diameter is 100 mm and length is 650 mm. The susceptor 16 per se is made of carbon, and a recess is made in the upper surface 43 thereof so as to receive and hold the substrate 15 therein. As a result, the substrate 15 is prevented from moving relative to the upper surface 43 of the susceptor 16. The outer surface of the susceptor 16 is coated with silicon carbide.

The tip end of the supporting shaft 19 is received in a center hole made in a lower surface of the susceptor 16, and this supporting shaft 19 is also made of silica glass. Furthermore, the gear 41, teeth 42 as well as rotary shaft 20 are made of silica glass. The reason that silica glass is used for these portions where rotational friction occurs is to prevent absorption of reactive gas by using inactive material and to prevent occurrence of undesired dust by using high hardness material. A susceptor supporting plate 18 is attached to the supporting shaft 19 and a spacer 17 made of carbon is interposed between the susceptor supporting plate 18 and the lower surface of the susceptor 16 for ensuring smooth rotation of the susceptor 16.

As the substrate 15 is used a GaAs substrate of 1 cm by 1 cm, and the inclination angle of the susceptor 16 with respect to horizontal plane corresponding to the axis of horizontal gas flow is set to 5 degrees in this embodiment. The rotational speed of the susceptor 16 is set to 1 rpm, and semiconductor growing temperature is 700 °C, while pressure is set to 20 Torr. Although the uniformity of the semiconductor to be produced is not directly affected by the rotational speed of the susceptor 16, an excessively high rotational speed causes the occurrence of undesirable dust at portions where friction occurs such as the gear 41, rotary shaft 20, and supporting shaft 19. For this reason, the rotational speed of the susceptor 16 is preferably below 3 rpm.

The following table shows the rate of lattice mismatching ($\Delta a/a$) measured in connection with compound semiconductor produced by using trimethylgallium (TMGa) and trimethylindium (TMIn) as organometal compounds of Group III, and arsine ($AsH_3$) and phosphine ($PH_3$) as compounds of Group V, where the ratio of V/III is 100, TMGa/(TMGa +TMIn) being varied as shown in the table, and gas flow rate being 24 cm/sec.

| EXPERIMENT No. | 1 | 2 | 3 | 4 | 5 | 6 |
|---|---|---|---|---|---|---|
| TMGa/(TMGa +TMIn) | 0.84 | | 0.85 | | 0.86 | |
| ROTATION OF SUBSTRATE | YES | NO | YES | NO | YES | NO |
| AVERAGE LATTICE MISMACHING (%) | 0.08 | 0.31 | 0 | 0.2 | -0.3 | -0.1 |
| VARIATIONS IN LATTICE MISMATCH-ING ($\pm$ %) | 0.05 | 0.30 | 0.03 | 0.25 | 0.05 | 0.30 |

Measuring accuracy of lattice constant: $\pm$ 0.03%

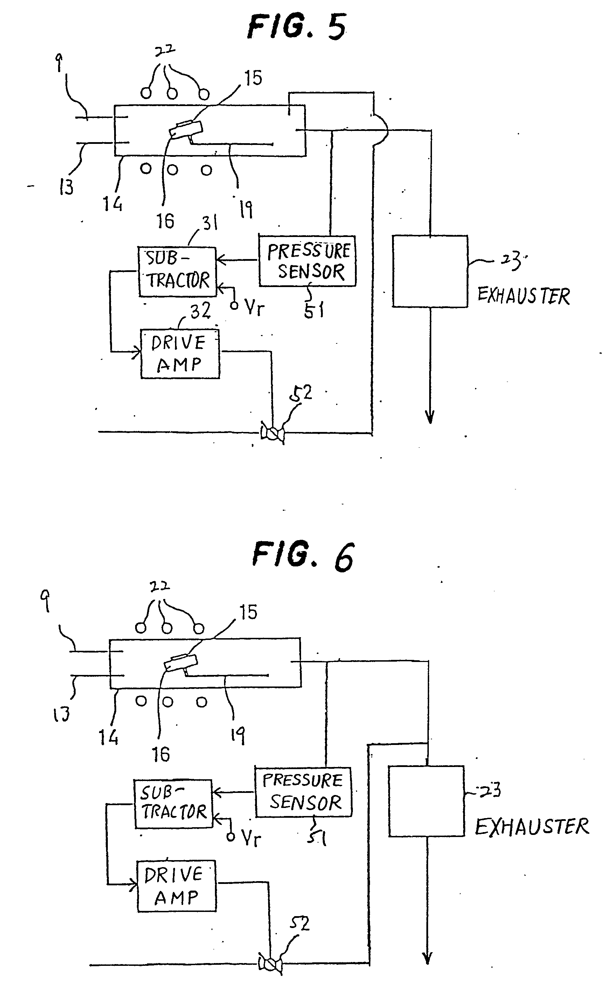

Although only one substrate 15 is used in the above-described embodiment, a plurality of substrates may be arranged on the upper surface 43 of the susceptor 16. The inclination angle of the substrate 15 with respect to the reactive gas flow of compound semiconductor starting materials must be less than 45 degrees because excessively inclined angle may cause the reactive gas flow to be disturbed thereby making it difficult to produce uniform quality compound semiconductor. The inclination angle is preferably below 30 degrees, and may equal to zero degree.     Fig. 5 shows partially a second embodiment apparatus according to the present invention. This embodiment differs from the first embodiment of Fig. 1 in that the pressure of exhaust gas is detected by a pressure sensor 51 to feedback control the flow rate of an inactive mixed gas of H2 and N2 to be fed to the reaction tube 14 near the outlet port, i.e. downstream of the susceptor 16, where the exhaust pipe 21 is connected. The reference 52 is a variable flow rate solenoid valve arranged to be controlled by an output drive signal from drive amplifier 32 responsive to the output signal from subtractor 31 to which the output signal from the pressure sensor 51 and the reference voltage Vr are respectively applied. The pressure sensor 51, the subtractor 31 and the drive amplifier 32 constitute a feedback path in the same manner as in the first embodiment. However, the reference voltage Vr indicates a desired or target exhaust gas pressure. Since the flow rate of inactive mixed gas fed to the downstream portion of the reaction tube 14 is controlled by the variable flow rate solenoid valve 52 in accordance with the detected pressure of the exhaust gas, the pressure

6

in the reaction tube 14 is accurately maintained constant.

Fig. 6 is a modification of the second embodiment of Fig. 5. In this embodiment, the output port of the variable flow rate solenoid valve 52is directly communicated with an upstream portion of the exhauster 23 for changing and controlling the exhaust gas speed in accordance with detected pressure of the exhaust gas. As the speed of flow of the exhaust gas is controlled, the pressure in the reaction tube 14 is maintained constant.

The above-described embodiment of Fig. 5 and its modification of Fig. 6 may be used with conventional organometal compound supply system. If desired, however, one of the structures of Fig. 5 and Fig. 6 may be added to the first embodiment of Fig. 1 so that feedback control is performed at both inlet side and outlet side of the reaction tube 14 thereby providing further accurate control.

From the foregoing description it will be understood that the present invention provides very accurate control of vapor pressure and flow rate of organometal compounds to be supplied to a reaction tube, and therefore, reproducibility of various components constituting a compound semiconductor, such as quaternary compound semiconductor is remarkably improved. Furthermore, flow rate variation caused from stepwise change of amount of supply of organometal compound gas to the reaction tube, which has been a problem on multi-layer growth of semiconductor crystal, can be suppressed to minimum, and therefore, crystal growth of satisfactory reproducibility is now available without utilizing a plurality of supply lines for respective organometal compounds. Moreover, the adjustment of pressure of starting gas and precise know-how on valve operation which have been inherent in the operation of the conventional apparatus are not required, and since the apparatus according to the present invention is resistant to external disturbance, the apparatus does not suffer from local variations.

As a result, between-lot variation of epitaxial growth wafers of compound semiconductor can be drastically reduced, while the capability of mass production is greatly improved.

## Claims

1. Apparatus for producing a compound semiconductor having a bubbler ( 4) for producing vaporized organometal compound by leading a carrier gas thereinto, and a reaction tube (14) for performing vapor phase growth of a semiconductor crystal on a substrate by leading said vaporized organometal compound to said reaction tube (14), characterized by first means (3B) provided between said bubbler and said reaction tube for accurately controlling flow rate of said vaporized organometal compound, second means (1) for detecting pressure of said vaporized organometal compound at outlet side of said bubbler (4), and third means (2) provided at inlet side of said bubbler (4) for controlling flow rate of said carrier gas in accordance with an output signal from said second means (1).

2. Apparatus as claimed in Claim 1, wherein said second means (1) comprises a pressure sensor for detecting the pressure of said vaporized gas, and a signal processing circuit (31) responsive to an output signal from said pressure sensor (1) and a reference signal (Vr) representing a desired pressure of said vaporized gas.

3. Apparatus as claimed in Claim 1 or 2 further comprising means (24) for maintaining the temperature of said organometal compound contained in said bubbler (4) substantially constant.

4. Apparatus for producing compound semiconductor having a bubbler (14) for producing vaporized organometal compound by leading a carrier gas thereinto, a reaction tube (14) for performing vapor phase growth of a semiconductor crystal on a substrate by leading said vaporized organometal compound to said reaction tube, and an exhauster (23) communicated with an outlet of said reaction tube (14) via an exhaust pipe for exhausting said vaporized organometal compound from said reaction tube (14), characterized by means (51, 52) responsive to pressure of said exhaust gas for maintaining pressure of said vaporized organometal compound within said reaction tube (U1) substantially constant.

5. Apparatus as claimed in Claim 4, wherein said means (51, 52) comprises means (51) for detecting pressure of said exhaust gas from said reaction tube (14), means for supplying inactive gas to said reaction tube (14) at a portion near outlet thereof, and means (52) for controlling flow rate of said inactive gas in accordance with said pressure of said exhaust gas.

6. Apparatus as claimed in Claim 4, wherein said means comprises means (52) for controlling flow speed of said exhaust gas from said reaction tube.

7. Apparatus as claimed in Claim 6, wherein said means comprises means (51) for detecting pressure of said exhaust gas from said reaction tube, means for supplying inactive gas to said exhaust pipe connected to an outlet of said reaction tube, and means (52) for controlling flow rate of said inactive gas in accordance with said pressure of said exhaust gas.

8. Apparatus for producing compound semiconductor having a reaction tube (14) for performing vapor phase growth of a semiconductor crystal on a substrate (43) carried by a susceptor (16) by leading vaporized organometal compound to said reaction tube (14) characterised in that said reaction tube (14) is a horizontal reaction tube so that said vaporized organometal compound is supplied in a horizontal direction to said substrate (43) an upper surface of said susceptor (16) is in inclined by an angle less than 45 degrees with respect to the general direction of flow of said vaporized organometal compound, and by means (20, 41, 42) for rotating said susceptor (16) about a center axis which is perpendicular to said upper surface of said susceptor (16).

9. Apparatus as claimed in Claim 8, wherein said susceptor (16) is supported within said reaction tube (14) by way of a supporting shaft (19) having a supporting plate (18), a freely rotatable spacer (17) made of carbon being interposed between lower surface of said susceptor (16) and said supporting plate (18).

10. Apparatus as claimed in Claim 8 or 9, further comprising means for maintaining pressure within said reaction tube (14) constant.

11. Apparatus as claimed in Claim 10, wherein said constant pressure maintaining means ccmprises means (51) for detecting pressure of an exhaust gas from said reaction tube (14), means for supplying inactive gas to said reaction tube at a portion near outlet thereof, and means (52) for controlling flow rate of said inactive gas in accordance with said pressure of said exhaust gas.

12. Apparatus as claimed in Claim 10, wherein said constant pressure maintaining means comprises means (52) for controlling speed of exhaust gas flow from said reaction tube.

13. Apparatus as claimed in Claim 12, wherein said constant pressure maintaining means comprises means (51) for detecting pressure of said exhaust gas from said reaction tube, means for supplying inactive gas to an exhaust pipe connected to an outlet of said reaction tube (14), and means (52) for controlling flow rate of said inactive gas in accordance with said pressure of said exhaust gas.

14. Apparatus for producing compound semiconductor having a bubbler (4) for producing vaporized organometal compound by leading a carrier gas thereinto, and a reaction tube (14) for performing vapor phase growth of a semiconductor crystal on a substrate carried by a susceptor (16) by leading said vaporized organometal compound to said reaction tube, characterised by first means (3B) provided between said bubbler (4) and said reaction tube (14) for accurately controlling flow rate of said vaporized organometal compound, second means (1) for detecting pressure of said vaporized organometal compound at outlet side of said bubbler (4), third means (2) provided at inlet side of said bubbler (4) for controlling flow rate of said carrier gas in accordance with an output signal from said second means (1), in that an upper surface of said susceptor (16) is inclined by an angle less than 45 degrees with respect to the general direction of flow of said vaporized organometal compound and by means (20, 41, 42) for rotating said susceptor about a center axis which is perpendicular to said upper surface of said susceptor (16).

15. Apparatus according to any one of claims 8 to 14 wherein said reaction tube (14) is a horizontal reaction tube so that said vaporized organometal compound is supplied in a horizontal direction to said substrate, said upper surface of the susceptor (16) is inclined at an angle of less than 45 degrees to the horizontal.

16. Apparatus for producing compound semiconductor having a bubbler (4) for producing vaporized organometal compound by leading a carrier gas thereinto, a reaction tube (14) for performing vapor phase growth of a semiconductor crystal on a substrate by leading said vaporized organometal compound to said reaction tube (14), and an exhauster (23) communicated with an outlet of said reaction tube (14) via an exhaust pipe for exhausting said vaporized organometal compound from said reaction tube (14), characterized by first means (3B) provided between said bubbler (4) and said reaction tube (14) for accurately controlling flow rate of said vaporized organometal compound, second means (1) for detecting pressure of said vaporized organometal compound at outlet side of said bubbler (4), third means (2) provided at inlet side of said bubbler (4), for controlling flow rate of said carrier gas in accordance with an output signal from said second means (1), and fourth rmeans responsive to pressure of said exhaust gas for maintaining pressure of said vaporized organometal compound within said reaction tube constant.

FIG. 1

# FIG. 2
## PRIOR ART

3A

H₂/N₂ →

→ (MO + H₂/N₂)

TO REACTOR

4

5

2

# FIG. 3
## PRIOR ART

3A

3B

H₂/N₂ →

(MO + H₂/N₂) →

TO REACTOR

4

5

2

*FIG. 4 A*

*FIG. 4 B*

EP 0 311 446 A2

# FIG. 5

# FIG. 6

# FIG. 7

# FIG. 8

The plot shows PL Intensity (LPE ≡1) on the vertical axis versus Solid Composition Z on the horizontal axis, labeled $(Al_z Ga_{1-z})_x In_{1-x} P$ at R.T.

O : HIGH PURITY SUSCEPTOR

● : SiC-COATED SUSCEPTOR